# EUROPÄISCHE PATENTSCHRIFT

(11) **EP 0 903 063 B1**
(45) Veröffentlichungstag und Bekanntmachung des Hinweises auf die Patenterteilung: **18.10.2000**
(21) Anmeldenummer: 97925973.6
(22) Anmeldetag: 30.05.1997
(51) Int. Cl.: H05K 5/00, H05K 5/04, H05K 9/00

(54) **GEHÄUSE**
HOUSING
BOITIER

(30) Priorität: 31.05.1996 DE 29609709 U
(43) Veröffentlichungstag der Anmeldung: 24.03.1999
(73) Patentinhaber: Knürr Mechanik für die Elektronik AG, D-81829 München (DE)
(72) Erfinder: BRANDT, Herwig, D-47229 Duisburg (DE); NENT, Heinz, D-41334 Nettetal (DE); RIPS, Siegbert, D-41334 Nettetal (DE); FLAMME, Hans, D-82008 Unterhaching (DE); RAITH, Robert, D-81541 München (DE)
(74) Vertreter: Heim, Hans-Karl, Dipl.-Ing.
(86) Internationale Anmeldenummer: EP9702837
(87) Internationale Veröffentlichungsnummer: WO9746064

(56) Entgegenhaltungen:
- DE-A- 2 215 061
- DE-U- 1 877 058
- DE-U- 9 110 261
- US-A- 4 652 969
- US-A- 5 015 802
- US-A- 5 031 791

## Beschreibung

Die Erfindung betrifft ein Gehäuse zur Aufnahme von elektrischen und elektronischen Baugruppen gemäß Oberbegriff des Anspruchs 1.

Gehäuse aus U-förmigen Halbschalen sind mit Front- und/oder Rückplatten versehen und werden in der Regel im Bereich ihrer seitlichen Längskanten mit Befestigungsschrauben, die bodenseitig oder deckenseitig eingeführt werden, miteinander verbunden.

Bei einem aus der DE 39 33 643 A1 bekannten Gehäuse sind Schwalbenschwanzprofile an der äußeren Gehäusewand ausgebildet. Eine aufschiebbare Halteplatte soll die Gehäuseschalen zusammenhalten und dient darüber hinaus zur Aufnahme eines Tragbügels. Nahe den Stirnseiten sind Rastelemente an Seitenflächen der oberen Halbschalbe ausgebildet, die in Rastkammern einer unteren Halbschale einrasten.

Die Herstellung dieses bekannten Gehäuses ist aufgrund seiner Konstruktion relativ kostenaufwendig. Außerdem entspricht das Gehäuse in seinem Gesamteindruck nicht in jedem Fall den ständig steigenden Anforderungen an formschöne und variabel einsetzbare Gehäuse.

Der Erfindung liegt die **Aufgabe** zugrunde, eine Konstruktion für ein kostengünstig herstellbares, formschönes Gehäuse zu schaffen, welches darüber hinaus bei Bedarf IP-dicht und EMV-abgeschirmt ausgebildet werden kann.

Erfindungsgemäß wird die Aufgabe durch die kennzeichnenden Merkmale des Anspruchs 1 gelöst. Zweckmäßige und vorteilhafte Ausgestaltungen sind Merkmale der Unteransprüche und in der Figurenbeschreibung enthalten.

Der Erfindung liegt die Überlegung zugrunde, ein Gehäuse aus zwei Halbschalen derart auszubilden, daß es aus jeweils einem einzigen Flachmaterialzuschnitt, z.B. einem Stahl- oder Aluminiumblech, hergestellt werden kann. Ausgehend von einem definierten Zuschnitt des Flachmaterials kann durch Abkantungen, Abwinklungen, gegebenenfalls auch Ausprägungen und Ausstanzungen, insbesondere in einem längsseitigen Kantenbereich der Halbschalen, ein fertigungstechnisch besonders vorteilhaftes Gehäuse erreicht werden.

Erfindungsgemäß wird jede Halbschale des Gehäuses aus einem Flachmaterialzuschnitt gebildet, der in Stirnseitenbereichen um 180° und zu einem Haltesteg abgewinkelt wird, wobei der Haltesteg endseitig und rechtwinklig zu dem Stirnseitenbereich sowie in eine front- und/oder rückseitige Öffnung ragend ausgebildet ist.

Vorteilhafterweise ist der Haltesteg, welcher die front- und/oder rückseitige Öffnung des Gehäuses begrenzt, zur Anlage oder Fixierung der Frontplatte bzw. der Rückplatte vorgesehen. Im zusammengebauten Zustand verläuft die Front- bzw. Rückplatte parallel zu den Haltestegen und ermöglicht damit eine besonders vorteilhafte IP-Abdichtung und/oder EMV-Abschirmung.

Es ist zweckmäßig, ein elastisches Dichtungsprofil als IP-Dichtung einzusetzen, welches beispielsweise als ein C- oder vorzugsweise U-Profil mit Dichtlippen ausgebildet ist und stirnseitig auf der Front- und/oder Rückplatte angeordnet werden kann. Das Dichtungsprofil weist wenigstens eine Dichtlippe auf, welche insbesondere abgeschrägt und nach außen gerichtet ausgebildet ist und unter Ausgleich von Toleranzschwankungen an den 180° abgewinkelten Stirnseitenbereichen anliegt.

Eine EMV-Federleiste ist insbesondere zur Fixierung an dem Haltesteg fixierbar und kann so mit einem beispielsweise bogenförmig ausgebildeten Kontaktbereich die Frontplatte kontaktieren.

Jede Halbschale ist durch Abkantungen bzw. durch Abwinklungen aus dem einstückigen Flachmaterialzuschnitt gebildet. Äußerst vorteilhaft ist die Abwinklung von Eckschrägen zwischen einer Deckfläche und den jeweils angrenzenden Längsseiten bzw. zwischen einer Bodenfläche und den angrenzenden Längsseiten. Im Bereich dieser Eckschrägen, welche unter einem Winkel von etwa 45° verlaufen können, sind die stirnseitigen, vorzugsweise nach innen versetzten Haltestege auf Gehrung geschnitten und können, beispielsweise durch eine Schweißverbindung, miteinander verbunden werden.

Die zwei Halbschalen, welche insbesondere identisch ausgebildet sind, grenzen im Bereich ihrer Längsseiten an Stoßstellen aneinander, wobei diese Stoßstellen in einer besonders effizienten Weise als Abkantungen oder Abwinklungen des einstückigen Flachmaterials ausgebildet sind.

Zweckmäßigerweise sind die Abkantungen der oberen und unteren Halbschale nach außen gerichtet und weisen wenigstens einen horizontalen Verbindungssteg auf.

Ein Zusammenbau des Gehäuses kann durch Eingriffselemente im Bereich der Abkantungen bzw. der Verbindungsstege besonders günstig gestaltet werden. Beispielsweise können Rastnoppen als kreisrunde Erhebungen an einem Verbindungssteg einer ersten Halbschale mit komplementär ausgebildeten Ausnehmungen im Verbindungssteg der zweiten Halbschale zusammenwirken. Für Rastnoppen und zugehörige Ausnehmungen empfiehlt sich die Ausbildung von nahezu U-förmigen Abkantungen an den Halbschalen, wobei ein derartiges U-förmiges Endprofil an der oberen Halbschale mit einer nach oben gerichteten Öffnung und bei einer unteren Gehäusehalbschale mit einer nach unten gerichteten U-förmigen Öffnung ausgebildet ist.

Zweckmäßigerweise ist der gesamte Bereich der Abkantungen, d.h. des Endprofils mit den Eingriffselementen, durch eine Seitenleiste abdeckbar. Diese Seitenleiste, beispielsweise ein Aluminium-Strangpreßprofil, ist zweckmäßigerweise auf die Abkantungen der miteinander verbundenen Gehäusehalbschalen aufschiebbar ausgebildet und weist komplementär zu den Abkantungen ausgebildete Ausnehmungen auf. Ein vorteilhafter Gesamteindruck kann erreicht werden, wenn die Seitenleisten farblich und konturenmäßig eine besondere Gestaltung aufweisen.

In einer Ausgestaltung kann ein Gehäuse bzw. ein Verbindungssteg einer oberen Gehäusehalbschale mit nahezu vertikal nach unten ausgerichteten, fingerartigen Verbindungselementen, z.B. Laschen, versehen sein. Diese Laschen wirken mit Öffnungen oder Taschen im Bereich der Abkantungen bzw. des Verbindungsstegs der unteren Gehäusehalbschale zusammen. Wenn die Verbindungsstege der oberen Halbschale und der unteren Halbschale aneinandergrenzen bzw. aneinanderstoßen, kann eine entsprechend ausgebildete Seitenleiste wiederum von einer Stirnseite her aufgeschoben werden, so daß die zusammengesteckten Gehäusehalbschalen zusätzlich verspannt und damit besonders sicher verbunden werden.

Die Frontplatte und/oder Rückplatte kann durch stirnseitig einführbare Befestigungsschrauben fixiert werden. In einer zweckmäßigen Ausbildung sind Endstücke vorgesehen, welche die Seitenleiste stirnseitig begrenzen. Die Endstücke können derart angeordnet bzw. z.B. auf die Abkantungen aufgeschoben oder auch aufgeklipst werden, daß sie mit den Stirnseitenbereichen fluchten.

In einer Weiterbildung sind die Endstücke, welche z.B. aus Polyamid gefertigt sein können, als ein Winkelstück und auf die Frontplatte bzw. Rückplatte übergreifend ausgebildet. Das Winkelstück kann auf die Seitenleiste und/oder den frontund rückseitigen Gehäusebereich aufgeklipst oder wie die Frontplatte in diesem Bereich zur Führung und Aufnahme eines Befestigungselementes, beispielsweise einer Befestigungsschraube, ausgebildet sein, so daß eine besonders einfache Befestigung möglich ist.

Eine weitere Ausgestaltung sieht vor, die Endstücke bzw. die Winkelstücke insbesondere im frontplattenseitigen Bereich gegen eine Tragegriff-Aufnahme austauschbar zu gestalten. In einer Tragegriff-Aufnahme kann ein Tragegriff lösbar und/oder verstellbar gehalten sein. Es ist dann z.B. möglich, das Gehäuse mit einer entsprechend einstellbaren Schräganordnung aufzustellen.

Die Erfindung soll nachstehend anhand einer Zeichnung weiter erläutert werden; in dieser zeigen in einer stark schematisierten Darstellung
- Fig. 1: ein erfindungsgemäßes Gehäuse in einer perspektivischen Darstellung mit zwei verschiedenen Befestigungsarten für eine Frontplatte;
- Fig. 2: einen horizontalen Schnitt durch einen Stirnseitenbereich mit einer IP-Dichtung und EMV-Abschirmung im Bereich einer teilweise dargestellten Frontplatte;
- Fig. 3: eine perspektivische Darstellung eines erfindungsgemäßen Gehäuses im Bereich einer linken, frontseitigen Gehäuseecke mit einer ersten Variante einer längsseitigen Abkantung mit Verbindungsstegen und Eingriffselementen und
- Fig. 4: eine perspektivische Darstellung eines Gehäuses analog zu Fig. 3, jedoch mit einer zweiten Variante einer Abkantung und Eingriffselementen.

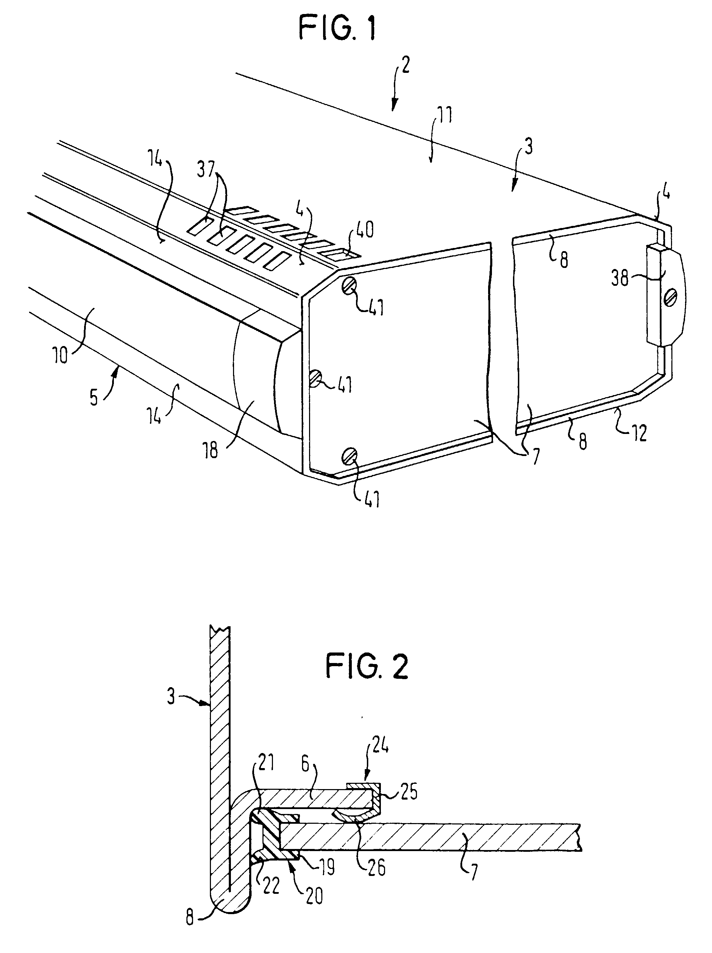

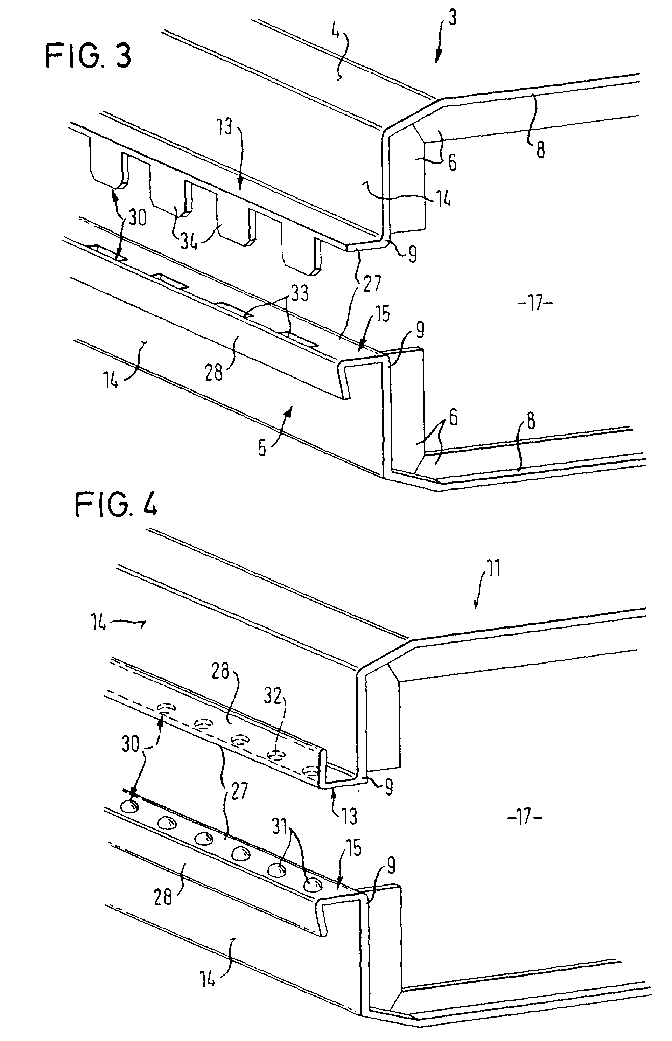

In Figur 1 ist ein erfindungsgemäßes Gehäuse 2 dargestellt. Es besteht aus zwei Halbschalen 3, 5, welche U-förmig ausgebildet sind und nach außen gerichtete Abkantungen (siehe Fig. 3 und Fig. 4) aufweisen, welche durch eine Seitenleiste 10 und angrenzende Endstücke 18 im Bereich der Stirnseiten abgedeckt sind.

Das Gehäuse 2 mit den zwei identischen U-förmigen Gehäusehalbschalen 3, 5, einer Frontplatte 7 und einer nicht dargestellten Rückplatte weist zwischen einer Deckfläche 11 und angrenzenden Seitenflächen 14 jeweils eine Eckschräge 4 auf. Im Bereich dieser Eckschrägen 4 können Lüftungslöcher oder Vertiefungen 37 vorgesehen sein. Ähnlich können auch Randbereiche der Deckfläche 11 ausgebildet sein. Eine stirnseitige Vertiefung 40 ist für einen Fuß (nicht dargestellt) vorgesehen, welcher als ein Klebe- oder Anschraubfuß ausgebildet sein kann.

Eine Frontplatte 7 ist in der linken Darstellung mit Hilfe von Befestigungsschrauben 41 befestigt.

Die rechte Variante zeigt ein Winkelstück 38 als ein auf die Frontplatte 7 übergreifendes Endstück 18. Dieses Winkelstück 38 ist in die Seitenleiste 10 einklipsbar oder auch durch eine Befestigungsschraube fixierbar. Die Frontplatte 7 verläuft nicht bündig mit den Stirnseitenbereichen 8, sondern ist in einer geschützten Anordnung nach innen versetzt angeordnet und fixiert.

In Figur 2 ist ein horizonaler Schnitt durch eine Frontplatte 7 und eine obere Halbschale 3 in einem Stirnseitenbereich 8 gezeigt. Dieser horizontale Schnitt verdeutlicht auch die Ausbildung eines Haltesteges 6 für die Frontplatte 7 an den 180° -abgewinkelten Stirnseitenbereichen 8. Der Haltesteg 6 verläuft nahezu im rechten Winkel zu den abgewinkelten, besonders stabilen Stirnseitenbereichen 8.

Zur IP-Abdichtung und EMV-Abschirmung sind Dichtungsprofile 20, 24 vorgesehen. Die IP-Abdichtung 20 weist ein etwa U-förmiges Profil 19 auf und umfaßt damit die Kantenbereiche der Frontplatte 7. Mit zwei schräg nach außen gerichteten Dichtlippen 21, 22 ist die Frontplatte 7 gegen den abgewinkelten Stirnseitenbereich 8 abgedichtet, wobei eine längere Dichtlippe 21 in das Gehäuseinnere und eine kürzere Dichtlippe 22 nach außen gerichtet ist. Diese Ausbildung der Dichtlippen 21, 22 geht aus Fig. 2 mit eingebauter Frontplatte und verformten Dichtlippen 21, 22 nicht hervor.

Eine EMV-Abschirmung wird durch eine Federleiste 24 als EMV-Dichtungsprofil gewährleistet, welches stirnseitig auf das freie Ende des Haltestegs 6 aufgeklemmt werden kann. Das EMV-Federelement oder die Federleiste 24 weist einen Haltebereich 25 und einen bogenförmigen Kontaktbereich 26 auf, welcher an der Frontplatte 7 anliegt.

In Figur 3 sind eine obere Gehäusehalbschale 3 sowie eine untere Gehäusehalbschale 5 mit längsseitigen Abkantungen 13, 15 dargestellt. Die Gehäusehalbschalen 3,5 sind nicht verbunden, sondern in Abstand voneinander gezeigt, so daß die Ausbildung der Abkantungen 13, 15 mit einem nahezu horizontalen Verbindungssteg 27 und Verbindungsfingern 34 oder Laschen sowie Öffnungen 33 oder Taschen als Eingriffselemente 30 deutlich hervorgeht. Die Verbindungsfinger 34 sind quadratisch bzw. rechteckig und vertikal nach unten gerichtet an dem horizontalen Verbindungssteg 27 der oberen Gehäusehalbschale 3 angeordnet und greifen in komplementär ausgebildete Öffnungen 33 des Verbindungsstegs 27 der unteren Gehäusehalbschale 5 ein. Es ist vorteilhaft, daß die Abkantungen, insbesondere die Verbindungsstege 27, zur Fixierung von Montageplatten und Bauteilen (nicht dargestellt) verwendet werden können.

Es ist möglich, die Verbindungsfinger 34 mit Krallen oder dergleichen EMV-abschirmend auszubilden. Die Längsseite 9 der oberen Gehäusehalbschale 3 ist, wie Figur 3 deutlich macht, nur mit dem Verbindungssteg 27 und den daran abgewinkelten Verbindungsfingern 34 versehen, während die untere Gehäusehalbschale 5 eine U-förmige Endprofilierung mit einem horizontalen Verbindungssteg 27 und einem nach unten abgekanteten Vertikalsteg 28 aufweist. An diesem Vertikalsteg 28 können sich die Verbindungsfinger 34 im zusammengebauten Zustand abstützen.

Eine frontseitige Öffnung 17 wird von einem nach innen versetzten Haltesteg 6 begrenzt, an welchem die Frontplatte 7 (siehe Fig. 1 und 2) mit ihren Randbereichen anliegt. Der Haltesteg 6 ist im Bereich der Eckschrägen auf Gehrung geschnitten.

Figur 4 zeigt eine zweite Variante der Eingriffselemente 30 und der oberen und unteren Abkantungen 13, 15. Diese sind als U-förmige Endprofile mit Verbindungsstegen 27 und mit einem nach oben bzw. nach unten gerichteten Endsteg 28 ausgebildet.

Als Eingriffselemente 30 sind beim Ausführungsbeispiel gemäß Figur 4 Rastnoppen 31 und komplementär ausgebildete Öffnungen 33 vorgesehen. Diese Eingriffselemente 30 sind rasterartig in den Verbindungsstegen 27 ausgebildet.

Im zusammengebauten Zustand werden die Abkantungen 13, 15 mit den Verbindungsstegen 27 und den Eingriffselementen 30 vollständig von einer Seitenleiste 10 (siehe Fig. 1) sowie Endstücken 18 abgedeckt. Die Seitenleiste 10 ist insbesondere stirnseitig aufschiebbar ausgebildet und mit einer innenseitigen Ausnehmung (nicht dargestellt) versehen, welche den aneinanderliegenden Abkantungen 13, 15 entspricht. Dasselbe trifft für die Endstücke 18 zu.

Es ist für einen besonders vorteilhaften Gesamteindruck möglich, die Endstücke 18 und die Seitenleiste 10 farblich vom Gehäuse abzusetzen und/oder mit einer ansprechenden Außenkontur zu versehen. Vorteilhaft ist die Verwendung von Kunststoffmaterial für die Seitenleiste und/oder die Endstücke, während die Gehäusehalbschalen 3, 5, die Frontplatte 7 und die Rückplatte (nicht dargestellt) aus einem Stahl- oder Aluminiumblech hergestellt werden können.

## Patentansprüche

1. Gehäuse, insbesondere zur Aufnahme von elektrischen und elektronischen Baugruppen, mit zwei Halbschalen (3, 5), welche U-förmig ausgebildet sind, einer Frontplatte (7) und einer Rückplatte,
dadurch **gekennzeichnet**,
daß jede Halbschale (3, 5) aus einem Flachmaterialzuschnitt gebildet ist,
daß der Flachmaterialzuschnitt in Stirnseitenbereichen (8) um 180° und jeweils zu einem Haltesteg (6) abgewinkelt ist und
daß der Haltesteg (6) rechtwinklig zu den Stirnseitenbereichen (8) und in eine front- oder rückseitige Öffnung (17) ragend ausgebildet ist.

2. Gehäuse nach Anspruch 1,
dadurch **gekennzeichnet**,
daß die Halbschalen (3, 5) identisch ausgebildet sind und Abkantungen (13, 15) zum längsseitigen Verbinden aufweisen, welche nach außen überstehen.

3. Gehäuse nach Anspruch 1 oder 2,
dadurch **gekennzeichnet**,
daß die Halbschalen (3, 5) zwischen einer Deckfläche (11) bzw. einer Bodenfläche (12) und angrenzenden Seitenflächen (14) Eckschrägen (4) aufweisen, welche durch Abwinklungen aus dem Flachmaterialzuschnitt gebildet sind und in deren Bereich der Haltesteg (6) auf Gehrung geschnitten ist.

4. Gehäuse nach einem der vorhergehenden Ansprüche,
dadurch **gekennzeichnet**,
daß die Frontplatte (7) und/oder Rückplatte an dem Haltesteg (6) IP-dicht und/oder EMV-abgeschirmt fixierbar ist.

5. Gehäuse nach einem der vorhergehenden Ansprüche,
dadurch **gekennzeichnet**,
daß die Frontplatte (7) und/oder Rückplatte mit einer IP-Dichtung (20) versehen ist, welche einen etwa U-förmigen Profilabschnitt (19) aufweist und stirnseitig auf die Front- und/oder Rückplatte (7) aufsteckbar ist und daß die IP-Dichtung (20) wenigstens eine Dichtlippe (21, 22) zur Abstützung an den 180° abgewinkelten Stirnseitenbereichen (8) der Halbschalen (3, 5) aufweist.

6. Gehäuse nach Anspruch 4 oder 5,
dadurch **gekennzeichnet**,
daß zur EMV-Abschirmung der Frontplatte (7) und/oder Rückplatte Federelemente oder eine Federleiste (24) vorgesehen sind/ist.

7. Gehäuse nach Anspruch 6,
dadurch **gekennzeichnet**,
daß die Federelemente (24) mit einem Haltebereich (25) auf das freie Ende des Haltesteges (6) aufschiebbar sind und mit einem Kontaktbereich (26) an der Frontplatte (7) und/oder Rückplatte anliegen.

8. Gehäuse nach einem der vorhergehenden Ansprüche,
dadurch **gekennzeichnet**,
daß die Abkantungen (13, 15) der Halbschalen (3, 5) U-förmig ausgebildet sind und horizontale Verbindungsstege (27) aufweisen, welche aneinandergrenzen und mit Eingriffselementen (30) versehen sind, welche insbesondere rasterartig angeordnet sind.

9. Gehäuse nach Anspruch 8,
dadurch **gekennzeichnet**,
daß als Eingriffselemente (30) Rastnoppen (31) und komplementär ausgebildete Ausnehmungen (32) in den aneinandergrenzenden Verbindungsstegen (27) ausgebildet sind.

10. Gehäuse nach Anspruch 8,
dadurch **gekennzeichnet**,
daß als Eingriffselemente (30) Verbindungsfinger oder Laschen (34) am Verbindungssteg (27) ausgebildet sind, welche vertikal nach unten gerichtet sind und in komplementäre Öffnungen oder Taschen (33) des Verbindungsstegs (27) der angrenzenden unteren, U-förmig ausgebildeten Abkantung (15) eingreifen.

11. Gehäuse nach Anspruch 8,
dadurch **gekennzeichnet**,
daß die Halbschalen (3, 5) im Bereich ihrer längsseitigen Abkantungen (13, 15) jeweils mit einer Seitenleiste (10) abdeckbar und/oder fixierbar sind und daß die Seitenleisten (10) als Profil ausgebildet und auf die längsseitigen Abkantungen (13, 15) unter Verspannung der Halbschalen (3,5) aufschiebbar sind.

12. Gehäuse nach Anspruch 11,
dadurch **gekennzeichnet**,
daß die Seitenleisten (10) front- und/oder rückseitig von Endstücken (18) begrenzt sind, welche unter Abdekkung der stirnseitigen Bereiche der Seitenleisten (10) mit den Stirnseitenbereichen (8) der Halbschalen (3, 5) nahezu fluchten oder daß Winkelstücke (38) als Endstücke (18) vorgesehen sind, welche auf die Frontplatte (7) oder Rückplatte übergreifen.

13. Gehäuse nach Anspruch 12,
dadurch **gekennzeichnet**,
daß die Endstücke (18) lösbar auf den Abkantungen (13, 15) und/oder Seitenleisten (10) und/oder Stirnseitenbereichen (8) der Gehäuseschalen (3, 5) gehalten und einklipsbar, verrastbar und/oder mit Schrauben sicherbar ausgebildet sind.

14. Gehäuse nach Anspruch 12 oder 13,
dadurch **gekennzeichnet**,
daß die Endstücke (18), insbesondere die frontseitigen Endstücke (18), als Tragegriff-Aufnahmen ausgebildet oder durch diese ersetzbar sind und daß ein Tragbügel lösbar und/oder verstellbar in den Tragegriff-Aufnahmen befestigt ist.

## Claims

1. Housing, particularly for receiving electrical and electronic units, having two U-shaped half-shells (3, 5), a front panel (7) and a rear panel,
**characterized** in that
each half-shell (3, 5) is formed from a flat material blank,
that the material blank is angled by 180° in the end face regions (8) to form in each case a holding web (6), and
that the holding web (6) is constructed at right angles to the end face regions (8) and projects into a front or rear opening (17).

2. Housing according to claim 1,
**characterized** in that
the half-shells (3, 5) have an identical construction and have folds (13, 15) for longitudinal side connection, which project towards outside.

3. Housing according to claim 1 or 2,
**characterized** in that
the half-shells (3, 5) have corner bevels (4) between a top face (11) or a bottom face (12) and adjacent lateral faces (14), the corner bevels (4) being formed by folds from the flat material blank, and the holding web (6) is mitre cut in the area of the corner bevels (4).

4. Housing according to one of the preceding claims,
**characterized** in that
the front panel (7) and/or rear panel can be fixed in IP-tight and/or EMC-shielded manner to the holding web (6).

5. Housing according to one of the preceding claims,
**characterized** in that
the front panel (7) and/or rear panel is provided with an IP-seal (20), which has an approximately U-shaped profile section (19) and can be frontally mounted on the front (7) and/or rear panel, and that the IP-seal (20) has at least one sealing lip (21, 22) for support on the 180° angled end face regions (8) of the halfshells (3, 5).

6. Housing according to claim 4 or 5,
**characterized** in that
spring elements or a spring strip (24) are provided for the EMC-shielding of the front (7) and/or rear panel.

7. Housing according to claim 6,
**characterized** in that
the spring elements (24) with a holding area (25) can be slid onto the free end of the holding web (6) and engage with a contact region (26) on the front (7) and/or rear panel.

8. Housing according to one of the preceding claims,
**characterized** in that
the folds (13, 15) of the half-shells (3, 5) are U-shaped having horizontal connecting webs (27), which are adjacent and provided with engagement elements (30), which are in particular arranged in grid-like manner.

9. Housing according to claim 8,
**characterized** in that
as engagement elements (30) are provided locking studs (31) and complementary constructed recesses (32) in the adjacent connecting webs (27).

10. Housing according to claim 8,
**characterized** in that
as engagement elements (30) connecting fingers or tongues (34) are constructed on the connecting web (27), which are directed vertically downwards and engage in complementary openings or cavities (33) of the connecting web (27) of the adjacent lower U-shaped fold (15).

11. Housing according to claim (8),
**characterized** in that
the half-shells (3, 5) can be covered and/or fixed in each case with a lateral strip (10) in the region of their longitudinal side folds (13, 15), and that the lateral strips (10) are constructed as profiles and can be slid onto the longitudinal side folds (13, 15), accompanied by the bracing of the half-shells (3, 5).

12. Housing according to claim 11,
**characterized** in that
the lateral strips (10) are defined at the front and/or back by end pieces (18), which are virtually aligned with the end face regions (8) of the half shells (3, 5), while covering frontal areas of the lateral strips (10), and that angle pieces (38) are provided as end pieces (18) which engage over the front panel (7) or rear panel.

13. Housing according to claim 12,
**characterized** in that
the end pieces (18) are detachably held on the folds (13, 15) and/or lateral strips (10) and/or face regions (8) of the housing shells (3, 5), and are constructed so as to be clippable, lockable and or securable with screws.

14. Housing according to claim 12 or 13,
**characterized** in that
the end pieces (18), particularly the front end pieces (18), are constructed as or are replaceable by carrying handle receptacles, and that a carrying handle is detachably and/or adjustably fastened in the carrying handle receptacles.

## Revendications

1. Boîtier, en particulier pour recevoir des sous-ensembles électriques et électroniques, avec deux demi-coques (3, 5) conformées en U, une plaque frontale (7) et une plaque arrière, ***caractérisé en ce que*** chaque demi-coque (3, 5) est formée d'une découpe de matériau plat, ***en ce que*** la découpe de matériau plat est coudée à 180° dans des zones frontales (8) et à chaque fois en direction d'une barre de retenue (6), et ***en ce que*** la barre de retenue (6) est conformée perpendiculaire aux zones frontales (8) et en saillie dans une ouverture (17) avant ou arrière.

2. Boîtier selon la Revendication 1, ***caractérisé en ce que*** les demi-coques (3, 5) sont conformées identiques et présentent des bordures (13, 15) servant à l'assemblage longitudinal, bordures qui forment saillie vers l'extérieur.

3. Boîtier selon la Revendication 1 ou *2, **caractérisé en ce que*** les demi-coques (3, 5) présentent entre une surface de dessus (11) ou bien une surface de fond (12), et des surfaces latérales adjacentes (14), des chanfreines (4) d'angle qui sont formés par des pliures de la découpe de matériau plat et sont coupés en biseau de niveau de la barre de retenue (6).

4. Boîtier selon l'une quelconque des Revendications précédentes, ***caractérisé en ce que*** la plaque frontale (7) et/ou la plaque arrière peut être fixée à la barre de retenue (6) avec un effet d'étanchéité normes IP et/ou de blindage électromagnétique.

5. Boîtier selon l'une quelconque des Revendications précédentes, ***caractérisé en ce que*** la plaque frontale (7) et/ou la plaque arrière est munie d'un joint normes IP (20), qui présente une section de profil (19) approximativement en U et peut être enfiché du côté frontal sur la plaque avant et/ou arrière (7), et ***en ce que*** le joint normes IP (20) présente au moins une lèvre d'étanchéité (21, 22) pour s'appuyer sur les zones frontales (8) coudées à 180° des demi-coques (3, 5).

6. Boîtier selon la Revendication 4 ou 5, ***caractérisé en ce que,*** pour le blindage électromagnétique de la plaque frontale (7) et/ou de la plaque arrière, des éléments ressorts ou une baguette élastique (24) est/sont prévus.

7. Boîtier selon la Revendication 6, ***caractérisé en ce que*** les éléments ressorts (24) peuvent être enfoncés avec une zone de retenue (25) sur l'extrémité libre de la barre de retenue (6) et s'appuient avec une zone de contact (26) contre la plaque frontale (7) et/ou la plaque arrière.

8. Boîtier selon l'une quelconque des Revendications précédentes, ***caractérisé en ce que*** les bordures (13, 15) des demi-coques (3, 5) sont conformées en U et présentent des barres de liaison (27) horizontales, qui sont adjacentes les unes aux autres et sont munies d'éléments d'emboîtement (30) qui sont disposés en particulier en réseau.

9. Boîtier selon la Revendication 8, ***caractérisé en ce que,*** comme éléments d'emboîtement (30), des nopes d'encliquetage (31) et des évidements (32) de forme complémentaire sont formés dans les barres de liaison contiguës (27).

10. Boîtier selon la Revendication 8, ***caractérisé en ce que,*** comme éléments d'emboîtement (30), des ergots de liaison ou des pattes (34) sont formés sur la barre de liaison (27), qui sont dirigés verticalement vers le bas et s'engagent dans des ouvertures ou pattes complémentaires (33) de la barre de liaison (27) de la bordure (15) inférieure adjacente conformée en U.

11. Boîtier selon la Revendication 8, ***caractérisé en ce que*** les demi-coques (3, 5) peuvent être enfichées et/ou fixées au niveau de leurs bordures (13, 15) longitudinales à chaque fois par une barre latérale (10) et ***en ce que*** les barres latérales (10) sont fabriquées en profilé et peuvent être enfoncées sur les bordures longitudinales (13, 15) avec serrage des demi-coques (3, 5).

12. Boîtier selon la Revendication 11, ***caractérisé en ce que*** les barres latérales (10) sont délimitées à l'avant et ou à l'arrière par des embouts (18) qui sont quasiment alignés avec les zones frontales (8) des demi-coques (3, 5) en recouvrant les zones frontales des barres latérales (10), ou ***en ce que*** des coins (38) sont prévus comme embouts (18), qui s'emboîtent sur la plaque avant (7) ou la plaque arrière.

13. Boîtier selon la Revendication 12, ***caractérisé en ce que*** les embouts (18) sont tenus de manière amovible sur les bordures (13, 15) et/ou les barres latérales (10) et/ou les zones frontales (8) des coques de boîtier (3, 5) et sont conformés clipsables, encliquetables et/ou fixables par des vis.

14. Boîtier selon la Revendication 12 ou 13, ***caractérisé en ce que*** les embouts (18), en particulier les embouts frontaux (18), sont conformés en logements de poignée ou peuvent être remplacés par ceux-ci, et ***en ce qu***'un arceau de transport est fixé de manière amovible et/ou réglable dans les logements de poignée.
